# FASCICULE DE BREVET EUROPEEN

(11) **EP 3 092 646 B1**
(45) Date de publication et mention de la délivrance du brevet: **11.09.2019**
(21) Numéro de dépôt: 15700434.2
(22) Date de dépôt: 07.01.2015
(51) Int. Cl.: G11C 11/419, G11C 11/00, G11C 11/16, G11C 14/00

(54) **PROCÉDÉ ET CIRCUIT POUR PROGRAMMER DES CELLULES DE MÉMOIRE NON VOLATILE D'UNE MATRICE MÉMOIRE VOLATILE/NON VOLATILE**
VERFAHREN UND SCHALTUNG ZUR PROGRAMMIERUNG NICHTFLÜCHTIGER SPEICHERZELLEN EINES FLÜCHTIGEN/NICHTFLÜCHTIGEN SPEICHERARRAY
METHOD AND CIRCUIT FOR PROGRAMMING NON-VOLATILE MEMORY CELLS OF A VOLATILE/NON-VOLATILE MEMORY ARRAY

(30) Priorité: 10.01.2014 FR 1450198
(43) Date de publication de la demande: 16.11.2016
(73) Titulaire: Commissariat à l'Energie Atomique et aux Energies Alternatives, 75015 Paris (FR); Centre National de la Recherche Scientifique, 75794 Paris Cedex 16 (FR)
(72) Inventeur: JAVERLIAC, Virgile, F-38100 Grenoble (FR); LAYER, Christophe, F-38000 Grenoble (FR)
(74) Mandataire: Cabinet Beaumont
(86) Numéro de dépôt international: PCT/EP2015/050179
(87) Numéro de publication internationale: WO 2015/104299

(56) Documents cités:
- DE-A1-102005 001 667
- FR-A1- 2 970 590
- US-A1- 2007 121 371
- US-A1- 2011 122 709
- US-A1- 2013 135 918

## Description

La présente demande de brevet revendique la priorité de la demande de brevet français FR14/50198 qui sera considérée comme faisant partie intégrante de la présente description.

### Domaine

La présente description concerne le domaine des réseaux de mémoire, et en particulier une matrice mémoire combinant une mémorisation de données volatiles et de données non volatiles.

### Arrière-plan

Il a déjà été proposé d'utiliser des éléments résistifs programmables dans des cellules mémoires pour assurer une mémorisation de données non volatile. De tels éléments résistifs sont programmables pour prendre l'un de deux états résistifs différents. L'état résistif programmé est conservé même lorsqu'une tension d'alimentation de la cellule mémoire est déconnectée, et ainsi des données peuvent être mémorisées par de tels éléments de façon non volatile.

Divers types d'éléments résistifs ont été proposés, dont certains sont capables d'être programmés par la direction d'un courant qu'on fait passer dans l'élément résistif. Un exemple d'un tel élément résistif programmable par un courant est un élément STT (à couple de transfert de spin), qui est basé sur des jonctions tunnel magnétiques (MTJ).

Une difficulté dans l'utilisation d'éléments résistifs pour la mémorisation de données est que les opérations de lecture et d'écriture ont tendance à être relativement lentes, ce qui entraine un temps d'accès élevé par rapport à une mémoire volatile standard comme une mémoire SRAM (mémoire statique à accès aléatoire). Pour résoudre cette difficulté, on a proposé de prévoir, dans chaque cellule mémoire, un circuit pour programmer l'état de l'élément résistif et pour lire, amplifier et mémoriser un état résistif programmé. Toutefois, bien qu'une telle solution conduise à une amélioration des temps d'accès, la surface utilisée par chaque cellule mémoire et la consommation d'énergie ont tendance à être élevées.

On a donc besoin dans la technique d'un réseau de mémoire non volatile ayant des temps d'accès relativement faibles et/ou une surface réduite par rapport à des mémoires non volatiles existantes.

La demande de brevet allemand publiée sous le numéro DE102005001667 concerne une cellule de mémoire non volatile.

La demande de brevet US publiée sous le numéro US2011/0122709 décrit un circuit logique non volatile comprenant une bascule.

La demande de brevet français publiée sous le numéro FR2970590 concerne un dispositif mémoire comprenant au moins une cellule mémoire.

La demande de brevet US publiée sous le numéro US2013/0135918 concerne un dispositif mémoire comprenant une cellule mémoire.

La demande de brevet US publiée sous le numéro US2007/0121371 concerne une cellule SRAM comprenant un circuit SRAM et un résistor programmable.

### Résumé

Un objet de modes de réalisation de la présente description est de résoudre au moins partiellement un ou plusieurs besoins de l'art antérieur.

Selon un aspect, on prévoit une matrice mémoire, chaque cellule comprenant : une pluralité de cellules de mémoire volatile comportant des premier et deuxième inverseurs couplés de façon croisée entre des premier et deuxième noeuds de mémorisation, le premier noeud de mémorisation étant couplé à une première ligne de bit par l'intermédiaire d'un premier transistor (214) et le deuxième noeud de mémorisation étant couplé à une deuxième ligne de bit par l'intermédiaire d'un deuxième transistor (216) ; une pluralité de cellules de mémoire non volatile, chaque cellule de mémoire non volatile étant couplée entre les première et deuxième lignes de bit et comportant au moins un élément résistif programmable pour prendre l'un d'au moins deux états résistifs, chaque élément résistif étant couplé en série avec un troisième transistor (220, 220A, 220B) ; et un circuit de commande adapté à activer les premier, deuxième et troisième transistors pour coupler une première des cellules de mémoire non volatile aux premier et deuxième noeuds de mémorisation d'une première des cellules de mémoire volatile pour générer un courant pour programmer l'état résistif dudit au moins un élément résistif.

Selon un mode de réalisation, ledit au moins un élément résistif est programmable par la direction d'un courant qu'on fait passer dans celui-ci pour prendre l'un desdits au moins deux états résistifs.

Selon un mode de réalisation, chaque cellule de mémoire non volatile comprend des premier et deuxième noeuds d'entrée, et le circuit de commande est adapté à coupler la première cellule de mémoire non volatile aux premier et deuxième noeuds de mémorisation de la première cellule de mémoire volatile en couplant le premier noeud d'entrée au premier noeud de mémorisation et en couplant le deuxième noeud d'entrée au deuxième noeud de mémorisation.

Selon un mode de réalisation, chaque cellule de mémoire non volatile comprend un seul élément résistif couplé en série avec un premier transistor entre les premier et deuxième noeuds d'entrée.

Selon un mode de réalisation, le circuit de commande est adapté à coupler la première cellule de mémoire non volatile aux premier et deuxième noeuds de mémorisation de la première cellule de mémoire volatile en activant le premier transistor.

Selon un mode de réalisation, chaque cellule de mémoire non volatile comprend : un premier élément résistif couplé en série avec un deuxième transistor entre le premier noeud d'entrée et un premier niveau de tension ; et un deuxième élément résistif couplé en série avec un troisième transistor entre le deuxième noeud d'entrée et le premier niveau de tension.

Selon un mode de réalisation, chaque cellule de mémoire volatile comprend : un quatrième transistor couplé entre le premier noeud de mémorisation et le premier noeud d'entrée de la cellule de mémoire non volatile ; un cinquième transistor couplé entre le deuxième noeud de mémorisation et le deuxième noeud d'entrée de la cellule de mémoire non volatile, et le circuit de commande est adapté à coupler la première cellule de mémoire non volatile aux premier et deuxième noeuds de mémorisation en activant les quatrième et cinquième transistors.

Selon un mode de réalisation, le premier noeud d'entrée est connecté à une première ligne de bit ; le deuxième noeud d'entrée est connecté à une deuxième ligne de bit ; le premier noeud de mémorisation est couplé à la première ligne de bit par l'intermédiaire du quatrième transistor ; et le deuxième noeud de mémorisation est couplé à la deuxième ligne de bit par l'intermédiaire du cinquième transistor.

Selon un mode de réalisation, le premier noeud d'entrée est connecté à un premier noeud interne ; le deuxième noeud d'entrée est connecté à un deuxième noeud interne ; le premier noeud de mémorisation est couplé au premier noeud interne par l'intermédiaire du quatrième transistor ; le deuxième noeud de mémorisation est couplé au deuxième noeud interne par l'intermédiaire du cinquième transistor; le premier noeud interne est couplé à une première ligne de bit par l'intermédiaire d'un sixième transistor ; le deuxième noeud interne est couplé à une deuxième ligne de bit par l'intermédiaire d'un septième transistor ; et le circuit de commande est adapté à désactiver les sixième et septième transistors pendant le couplage de la première cellule de mémoire non volatile aux premier et deuxième noeuds de mémorisation.

Selon un mode de réalisation, une deuxième des cellules de mémoire volatile comporte des troisième et quatrième inverseurs couplés de façon croisée entre des troisième et quatrième noeuds de mémorisation, le troisième noeud de mémorisation étant couplé au premier noeud interne par l'intermédiaire d'un huitième transistor et le quatrième noeud de mémorisation étant couplé au deuxième noeud interne par l'intermédiaire d'un neuvième transistor ; et une deuxième des cellules de mémoire non volatile comporte : au moins un élément résistif programmable pour prendre l'un d'au moins deux états résistifs ; un troisième noeud d'entrée connecté au premier noeud interne ; et un quatrième noeud d'entrée connecté au deuxième noeud interne.

Selon un mode de réalisation, la matrice mémoire comprend en outre un circuit de lecture/écriture adapté à lire dans la première cellule de mémoire non volatile un état résistif programmé représentant un premier bit de données et à écrire le premier bit de données dans la première cellule de mémoire volatile.

Selon un mode de réalisation, chacune des cellules de mémoire volatile est couplée à un rail d'alimentation en tension couplé par l'intermédiaire d'un commutateur à un niveau de tension d'alimentation.

Selon un mode de réalisation, ledit au moins un élément résistif de chacune des cellules de mémoire non volatile est de l'un des types suivants : un élément à couple de transfert de spin ayant une anisotropie dans le plan ; un élément à couple de transfert de spin ayant une anisotropie perpendiculaire au plan ; et un élément à oxydoréduction.

Selon un autre aspect, on prévoit un procédé de sauvegarde de données dans la matrice mémoire susmentionnée, le procédé comprenant : coupler, par un circuit de commande, la première cellule de mémoire non volatile aux premier et deuxième noeuds de mémorisation de la première cellule de mémoire volatile pour générer un courant pour programmer l'état résistif dudit au moins un élément résistif.

Selon un autre aspect, on prévoit un procédé de restauration de données dans la matrice mémoire susmentionnée, le procédé comprenant : lire dans la première cellule de mémoire non volatile un état résistif programmé représentant un premier bit de données ; et écrire le premier bit de données dans la première cellule de mémoire volatile.

### Brève description des dessins

Les caractéristiques et avantages susmentionnés, et d'autres, apparaîtront clairement à lecture de la description détaillée suivante de modes de réalisation, donnés à titre d'illustration et non de limitation, en faisant référence aux dessins joints dans lesquels :
la figure 1 illustre schématiquement un exemple de bascule non volatile ;
la figure 2 illustre schématiquement une partie d'une matrice de mémoire non volatile/volatile selon un exemple de réalisation ;
la figure 3 illustre schématiquement une cellule de mémoire non volatile selon un exemple de réalisation ;
la figure 4 illustre schématiquement un agencement de cellules de mémoire volatile et non volatile selon un autre exemple de réalisation ;
la figure 5 illustre schématiquement un agencement de cellules de mémoire volatile et non volatile selon des exemples de réalisation ;
la figure 6 illustre schématiquement une cellule de mémoire volatile plus en détail selon un exemple de réalisation ;
la figure 7A illustre schématiquement un dispositif à mémoire non volatile/volatile selon un exemple de réalisation ;
la figure 7B illustre schématiquement plus en détail un multiplexeur de colonne du dispositif mémoire de la figure 7A selon un exemple de réalisation ;
la figure 8 est un chronogramme représentant des exemples de signaux dans la matrice mémoire de la figure 7A selon un exemple de réalisation ;
la figure 9 illustre schématiquement un dispositif à mémoire non volatile/volatile selon un autre exemple de réalisation ; et
la figure 10 est un chronogramme représentant des exemples de signaux dans le dispositif mémoire de la figure 9 selon un exemple de réalisation.

### Description détaillée

Dans la description suivante, le terme "connecté" est utilisé pour faire référence à une connexion directe entre un élément et un autre, tandis que le terme "couplé" implique que la connexion entre les deux éléments peut être directe, ou se faire par l'intermédiaire d'un élément intermédiaire, comme un transistor, une résistance ou un autre composant.

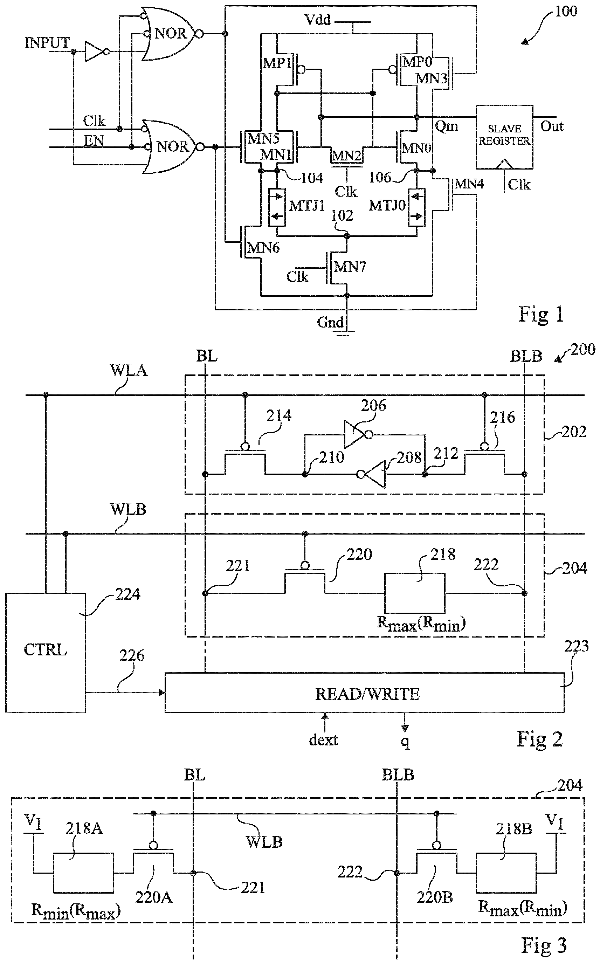

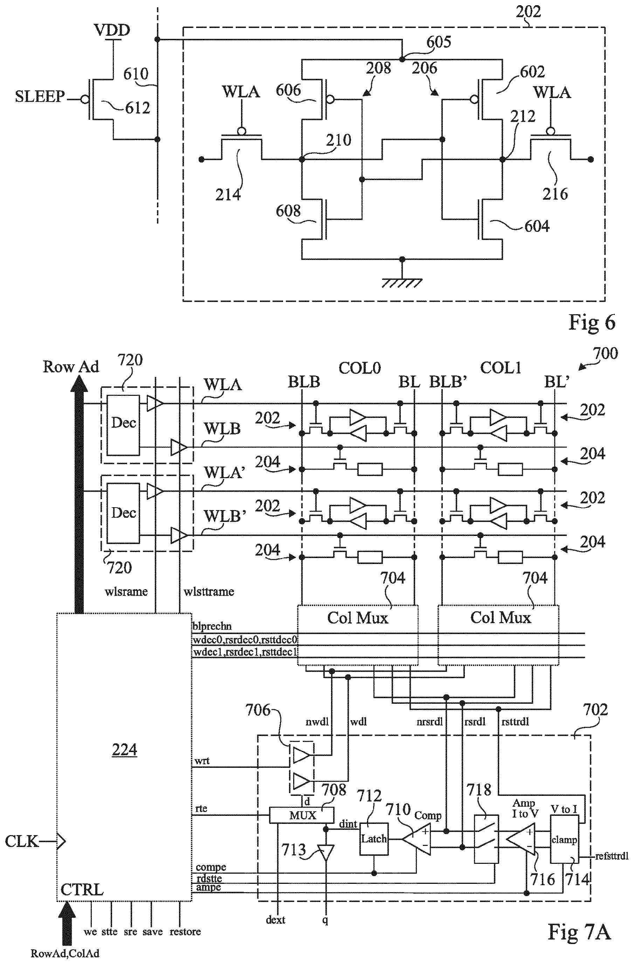

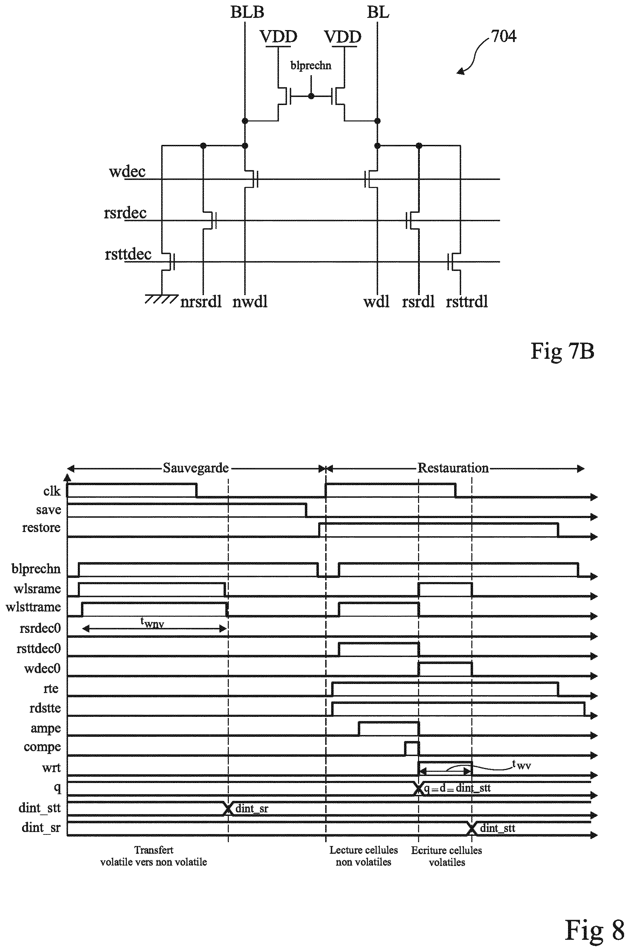

La figure 1 reproduit sensiblement la figure 7 de la publication intitulée " Spin-MTJ based Non-Volatile Flip-Flop", Weisheng Zhao et al., Proceedings of the 7th IEEE International Conférence on Nanotechnology, August 2-5, 2007, Hong-Kong.

La bascule 100 représentée en figure 1 comprend un registre maître et un registre esclave (SLAVE REGISTER). Le registre maître comprend des dispositifs à jonction tunnel magnétique MTJ1 et MTJO, programmables par la direction d'un courant qu'on fait passer dans ceux-ci. Le dispositif MTJ1 est connecté entre un noeud intermédiaire 104 et un noeud d'interconnexion 102. Le dispositif MTJO est connecté entre un noeud intermédiaire 106 et le noeud d'interconnexion 102. Le noeud d'interconnexion 102 connecte entre eux les dispositifs MTJ MTJO et MTJ1. Le noeud intermédiaire 104 est en outre couplé à une tension d'alimentation Vdd par l'intermédiaire d'une paire de transistors MN1 et MP1 couplés en série et formant un premier inverseur. Le noeud intermédiaire 106 est en outre couplé à la tension d'alimentation Vdd par l'intermédiaire d'une paire de transistors MP0 et MN0 couplés en série et formant un deuxième inverseur. Les premier et deuxième inverseurs sont couplés entres eux de façon croisée, et la sortie du deuxième inverseur est connectée au registre esclave. Un transistor MN2 est couplé entre les noeuds de grille des transistors MN1 et MN0.

Un transistor MN5 est couplé entre le noeud intermédiaire 104 et la tension d'alimentation Vdd, et un transistor MN6 est couplé entre le noeud intermédiaire 104 et la masse. En outre, un transistor MN3 est couplé entre le noeud intermédiaire 106 et la tension d'alimentation Vdd, et un transistor MN4 est couplé entre le noeud intermédiaire 106 et la masse. Un transistor MN7 est couplé entre le noeud intermédiaire 102 et la masse. Les transistors MN3 à MN6 permettent le passage d'un courant à travers les éléments résistifs MJT1 et MTJO dans une direction ou l'autre afin de programmer les états résistifs des dispositifs MTJ. Pendant cette phase de programmation, le transistor MN7 est utilisé pour déconnecter le noeud 102 de la masse. Deux portes du type NON OU et un inverseur sur le côté gauche de la figure 1, qui sont contrôlés par un signal d'entrée INPUT, un signal d'horloge Clk et un signal de d'activation EN, génèrent des signaux pour contrôler les transistors MN3 à MN6. Lorsque le transistor MN7 est activé, les transistors MP0, MP1, MN0 et MN1 forment un amplificateur de détection pour lire les états des éléments MTJ0 et MTJ1.

La cellule mémoire formant le registre maître de la figure 1 n'est pas adaptée à une utilisation dans une matrice mémoire au vu de son nombre relativement élevé de transistors. En outre, les transistors constituant l'amplificateur de détection sont relativement gros, puisqu'ils doivent être capables de faire passer un courant suffisant pour permettre aux états résistifs des éléments MTJ0 et MTJ1 d'être détectés.

La figure 2 illustre schématiquement un circuit 200 associé à une colonne d'une matrice mémoire combinée non volatile/volatile selon un exemple de réalisation de la présente description.

Le circuit 200 comprend une cellule de mémoire volatile 202, et une cellule de mémoire non volatile 204 associée à la cellule de mémoire volatile 202. Comme cela apparaîtra clairement dans la suite, les cellules de mémoire volatile et non volatile sont associées entres elles en ce que, au moins une certaine partie du temps, la cellule de mémoire non volatile 204 mémorise une sauvegarde d'un bit de données maintenu par la cellule de mémoire volatile 202, et peut être utilisée pour restaurer ce bit de données dans la cellule de mémoire volatile 202. Dans l'exemple de la figure 2 les cellules mémoires 202, 204 sont couplées entre une même paire de lignes de bit BL, BLB.

Bien que la figure 2 illustre une seule cellule de mémoire volatile 202 et une seule cellule de mémoire non volatile 204, la colonne peut comprendre un nombre quelconque de cellules volatiles et de cellules non volatiles associées couplées entre les lignes de bit BL et BLB. En outre, bien qu'une seule colonne soit illustrée en figure 2, la matrice mémoire peut comprendre un nombre quelconque de colonnes du type représenté en figure 2, chacune ayant un circuit de lecture/écriture correspondant décrit plus en détail ci-après.

La cellule de mémoire volatile 202 est par exemple une cellule SRAM (mémoire statique à accès aléatoire), comprenant une bascule formée par deux inverseurs 206, 208 couplés de façon croisée entre des noeuds de mémorisation 210, 212. Un transistor 214, qui est par exemple un transistor PMOS, couple le noeud de mémorisation 210 à la ligne bit BL. Un transistor 216, qui est aussi par exemple un transistor PMOS, couple le noeud de mémorisation 212 à la ligne de bit BLB. Les transistors 214 et 216 sont par exemple contrôlés par une ligne de sélection de rangée WLA de la matrice mémoire.

La cellule de mémoire non volatile 204 comprend par exemple un élément résistif programmable 218 couplé en série avec un transistor 220, qui est par exemple un transistor PMOS, entre des noeuds d'entrée 221, 222 de la cellule. Dans l'exemple de la figure 2, ces noeuds d'entrée 221, 222 sont connectés aux lignes de bit BL et BLB respectivement. Le transistor 220 est par exemple contrôlé par une ligne de sélection de rangée WLB de la matrice mémoire.

L'élément résistif 218 est par exemple un élément à commutation de résistance d'un type quelconque pour lequel la résistance est programmable par la direction d'un courant qu'on fait passer dedans. L'élément résistif 218 est par exemple un élément STT (transfert de couple de spin) ayant une anisotropie dans le plan ou perpendiculaire au plan, comme cela est décrit plus en détail dans la publication intitulée "Magnonic spin-transfer torque MRAM with low power, high speed, and error-free switching", N.Mojumder et al., IEDM Tech. Digest (2010), and in the publication entitled "Electric toggling of magnets", E. Tsymbal, Natural Materials Vol 11, January 2012. À titre de variante, les éléments résistifs pourraient être ceux utilisés dans des mémoires à commutation de résistance du type RAM RedOx (RAM à oxydoréduction), qui sont par exemple décrites plus en détail dans la publication intitulée "Redox-Based Resistive Switching Memories - Nanoionic Mechanisms, Prospects and Challenges", Rainer Waser et al., Advanced Materials 2009, 21, pages 2632 to 2663.

Quel que soit le type d'élément résistif, un bit de donnée est par exemple mémorisé de façon non volatile en programmant l'élément de façon à avoir soit une résistance relativement élevée (Rₘₐₓ) soit une résistance relativement faible (Rₘᵢₙ). L'élément résistif 218 par exemple a seulement deux états résistifs correspondant aux résistances haute et basse Rₘₐₓ et Rₘᵢₙ, mais les valeurs exactes de Rₘᵢₙ et Rₘₐₓ peuvent varier en fonction de conditions comme le processus de fabrication, les matériaux, les variations de température, etc. L'élément résistif 218 est par exemple choisi de telle sorte que la résistance Rₘₐₓ soit toujours notablement supérieure à Rₘᵢₙ, par exemple supérieure d'au moins 20 pourcent. En général, le rapport entre la résistance Rₘₐₓ et la résistance Rₘᵢₙ est par exemple compris entre 1,2 et 10000. Rₘᵢₙ est par exemple de l'ordre de 2 kilo-ohms ou moins, et Rₘₐₓ est par exemple de l'ordre de 6 kilo-ohms ou plus, bien que de nombreuses autres valeurs soient possibles.

Les lignes de bit BL et BLB sont couplées à un circuit de lecture/écriture (READ/WRITE) 223. Un circuit de commande 224 fournit des signaux de commande sur une ligne 226 vers le circuit de lecture/écriture 223, et aux lignes de sélection WLA et WLB.

Le circuit de lecture/écriture 223 est capable de lire un bit de donnée dans la cellule de mémoire volatile 202, par exemple en pré-chargeant les lignes de bit BL et BLB avec une tension élevée, et en détectant une chute de tension sur l'un ou l'autre des bits lorsque le signal WLA est activé par le circuit de commande 224. Le circuit de lecture/écriture 223 est aussi capable de lire un bit de données dans la cellule de mémoire non volatile 204, par exemple en appliquant une tension entre les lignes de bit BL, BLB pendant que le signal WLB est activé par le circuit de commande 224, afin de générer un courant dans l'élément résistif 218. Le niveau de ce courant est par exemple comparé à un courant de référence afin de déterminer l'état résistif programmé de l'élément 218. La donnée lue dans la cellule de mémoire non volatile 202 ou la cellule de mémoire volatile 204 peut être fournie sous la forme d'un signal q au niveau d'une sortie du circuit de lecture/écriture 223, et/ou écrite dans l'une des cellules de mémoire volatile pendant une opération de restauration, comme cela va être expliqué plus en détail.

Pendant une phase de sauvegarde, le circuit de commande 224 est capable de contrôler les cellules de mémoire volatile et non volatile de la matrice de sorte qu'une donnée est transférée de la cellule de mémoire volatile 202 vers la cellule de mémoire non volatile associée 204. In particulier, le circuit de commande 224 active les signaux de sélection WLA et WLB, de sorte que les transistors 214, 216 et 220 des cellules mémoires 202 et 204 sont activés. Les noeuds de mémorisation 210, 212 sont ainsi respectivement couplés aux noeuds d'entrée 221, 222 de la cellule de mémoire non volatile 204, et un courant d'écriture va circuler dans une direction ou dans l'autre à travers l'élément résistif 218 pour programmer son état, en fonction de la donnée maintenue par les noeuds de mémorisation 210, 212. En fonction du type et des dimensions de l'élément résistif 218, la taille des transistors constituant les inverseurs 206, 208 de la cellule mémoire 202 est par exemple choisie de façon à générer un courant d'écriture de l'ordre de 10 à 500 µA.

Le circuit de lecture/écriture 223 est aussi capable d'écrire un bit de donnée dans la cellule de mémoire volatile 202 par l'intermédiaire des lignes de bit BL et BLB. Cette donnée peut être une donnée externe dext fournie au circuit de lecture/écriture 223, ou une donnée interne lue dans l'une des autres cellules mémoires, par exemple la cellule de mémoire volatile 202. Par exemple, pendant une phase de restauration, un bit de donnée est lu par le circuit de lecture/écriture 223 dans la cellule de mémoire non volatile 204, et est écrit dans la cellule de mémoire volatile 202. L'opération d'écriture implique l'application par le circuit de lecture/écriture 223 d'une tension haute sur la ligne de bit BL et d'une tension basse sur la ligne de bit BLB, ou vice versa, en fonction de la donnée à écrire. Le circuit de commande 224 active ensuite le signal WLA, par exemple à un niveau bas, pour activer les transistors 214, 216, de sorte que la bascule formée par les inverseurs 206, 208 est programmée sur la base des tensions se trouvant sur les lignes de bit BL, BLB.

Bien que la figure 2 représente un exemple des circuits formant les cellules de mémoire volatile et non volatile 202, 204, il sera clair pour l'homme de l'art que dans des variantes de réalisation on pourrait utiliser des circuits différents.

La figure 3 illustre la cellule de mémoire non volatile 204 selon une variante de réalisation par rapport à celle représentée en figure 2. En particulier, plutôt que de comprendre un seul élément résistif 218, le circuit de la figure 3 comprend deux éléments résistifs 218A, 218B. L'élément 218A est couplé en série avec un transistor 220A, qui est par exemple un transistor PMOS, entre la ligne de bit BL et une tension d'alimentation intermédiaire V_{I}. De façon similaire, l'élément 218B est couplé en série avec un transistor 220B, qui est par exemple un transistor PMOS, entre la ligne de bit BLB et la tension d'alimentation intermédiaire V_{I}. Par exemple, les éléments résistifs 218A et 218B ont chacun l'un de leurs noeuds couplé à la tension V_{I}, et l'autre noeud couplé à la ligne de bit correspondante. Comme on va le décrire plus en détail ci-après, la tension d'alimentation intermédiaire V_{I} est par exemple égale à ou proche de la moitié de la valeur de la tension d'alimentation VDD. Les transistors 220A, 220B sont par exemple contrôlés par la ligne de sélection WLB.

Le bit de donnée non volatile représenté par les éléments résistifs 218A, 218B dépend duquel des éléments résistifs a la résistance Rₘₐₓ ou Rₘᵢₙ, en d'autres termes des résistances relatives. Les valeurs de Rₘₐₓ et de Rₘᵢₙ sont par exemple les mêmes que pour l'élément résistif 218 de la figure 2 décrit précédemment. En figure 3, l'élément résistif 218A est représenté programmé pour avoir une résistance Rₘᵢₙ et l'élément 218B une résistance Rₘₐₓ, et comme cela est représenté par les références Rₘₐₓ et Rₘᵢₙ entre parenthèses, la programmation opposée des valeurs de résistance serait possible.

En fonctionnement, le circuit de lecture/écriture 223 de la figure 2 écrit dans la cellule de mémoire non volatile 204 de la figure 3 de la même façon que cela a été décrit précédemment en relation avec la figure 2, en activant les signaux de sélection de rangée WLA et WLB. Ainsi les deux transistors 220A et 220B vont être activés, ce qui provoque le passage de courants dans chacun des éléments résistifs 218A, 218B. La tension haute sur le noeud de mémorisation 210 ou 212 est par exemple à un niveau VDD compris entre 2 et 3 V, la tension basse sur l'autre des noeuds de mémorisation 210, 212 est par exemple à la masse, et la tension intermédiaire V_{I} est par exemple à environ VDD/2, par exemple entre 1 et 1,5 V. Ainsi un courant va circuler dans chacun des éléments résistifs 218A, 218B dans une direction différente en fonction de la donnée mémorisée sur les noeuds de mémorisation.

Le circuit de lecture/écriture 223 lit l'état résistif relatif des éléments résistifs 218A, 218B en appliquant une tension, par exemple la tension d'alimentation VDD ou la masse, à chacune des lignes de bit BL, BLB, pendant que le signal WLB est activé, puis en comparant, en utilisant un comparateur, le niveau du courant circulant vers ou à partir de chaque ligne de bit.

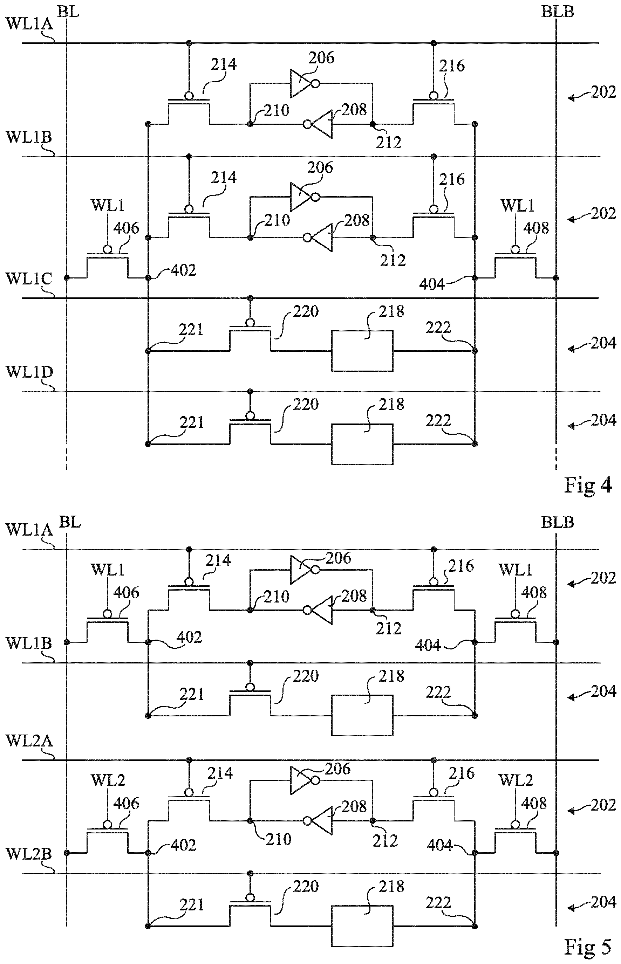

La figure 4 illustre schématiquement un agencement de cellules de mémoire volatile et non volatile 202, 204 selon un exemple de variante par rapport à l'agencement de la figure 2, dans lequel les cellules d'un groupe des cellules mémoires se trouvant dans une colonne sont couplées entre des noeuds internes 402, 404. Dans l'exemple de la figure 4, le groupe de cellules mémoires comprend deux cellules de mémoire volatile 202 et deux cellules de mémoire non volatile 204 couplées entre les noeuds internes 402, 404. Dans des variantes de réalisation, il pourrait y avoir plus que deux cellules de mémoire volatile et non volatile. Le noeud interne 402 est couplé à la ligne de bit BL par l'intermédiaire d'un transistor PMOS 406, et le noeud interne 404 est couplé à la ligne de bit BLB par l'intermédiaire d'un transistor PMOS 408. Les transistors 406, 408 sont contrôlés par un signal de sélection de groupe WL1, pendant que les cellules mémoires reçoivent respectivement des signaux de sélection WL1A, WL1B, WL1C et WL1D.

Bien que cela ne soit pas illustré en figure 4, il pourrait y avoir d'autres groupes de cellules de mémoire volatile et non volatile couplés entre les lignes de bit BL, BLB.

En fonctionnement, pendant une opération de lecture ou d'écriture des cellules mémoires 202, 204, les transistors 406, 408 sont activés en plus des transistors 214, 216 ou 220. Toutefois, lorsque des données doivent être transférées à partir de l'une des cellules de mémoire volatile vers l'une des cellules de mémoire non volatile, les transistors 406, 408 restent désactivés. De cette façon, une telle opération de transfert de données peut être réalisée en même temps dans chacun des groupes de cellules mémoires couplés aux mêmes lignes de bit BL et BLB.

La figure 5 illustre schématiquement des cellules de mémoire volatile et non volatile 202, 204 selon une variante de réalisation similaire à celle de la figure 4, excepté que chaque groupe de cellules mémoires comprend seulement deux cellules mémoires, une cellule de mémoire volatile 202 et une cellule de mémoire non volatile associée 204. Dans un tel agencement, les bits de données mémorisés par toutes les cellules de mémoire volatile 202 de chaque colonne de la matrice mémoire peuvent tous être transférés en même temps vers leurs cellules de mémoire non volatile 204 associées. En effet, un premier groupe de cellules mémoires de la figure 5 est contrôlé par les signaux de sélection WL1, WL1A et WL1B, et un deuxième groupe de cellules mémoires est contrôlé par les signaux de sélection WL2, WL2A et WL2B.

On notera que les cellules de mémoire non volatile 204 des figures 4 ou 5 pourraient être mises en oeuvre par le circuit de la figure 3, les transistors 220A, 220B étant couplés aux noeuds internes 402, 404.

La figure 6 illustre l'une des cellules de mémoire volatile 202 plus en détail selon un exemple de réalisation. L'inverseur 206 est par exemple constitué d'un transistor PMOS 602 et d'un transistor NMOS 604 couplés en série entre un noeud d'alimentation 605 et la masse. Les noeuds de commande des transistors 602, 604 sont couplés au noeud de mémorisation 210, et un noeud intermédiaire entre ces transistors constitue le noeud de mémorisation 212. De façon similaire, l'inverseur 208 est par exemple constitué d'un transistor PMOS 606 et d'un transistor NMOS 608 couplés en série entre le noeud d'alimentation 605 et la masse. Les noeuds de commande des transistors 606, 608 sont couplés au noeud de mémorisation 212, et un noeud intermédiaire entre ces transistors constitue le noeud de mémorisation 210.

Le noeud d'alimentation 605 est par exemple couplé à un rail d'alimentation en tension 610, qui est à son tour couplé à une tension d'alimentation VDD par l'intermédiaire d'un transistor PMOS 612 contrôlé par un signal de sommeil SLEEP. Le rail d'alimentation 610 alimente par exemple toutes les cellules de mémoire volatile de la colonne, et ainsi en désactivant le transistor 612, les cellules de mémoire volatile peuvent avoir leur alimentation coupée pour économiser l'énergie. En particulier, avant de passer dans le mode de sommeil, les données provenant de chacune des cellules de mémoire volatile 202 sont par exemple sauvegardées dans leurs cellules de mémoire non volatile 204 associées, puis les cellules de mémoire volatile ont leur alimentation coupée en désactivant le transistor 612. À la fin de la période de sommeil, le transistor 612 est par exemple activé pour alimenter les cellules de mémoire volatile 202, et les données mémorisées par chacune des cellules de mémoire non volatile 204 sont par exemple restaurées dans leurs cellules de mémoire volatile associées.

La figure 7A illustre schématiquement un dispositif mémoire 700 comprenant le circuit 200 de la figure 2 selon un exemple de réalisation. La façon dont ce dispositif pourrait être adapté pour fonctionner sur la base des cellules mémoires des figures 3 apparaîtra clairement à l'homme de l'art.

Deux colonnes COLO et COL1 sont illustrées en figure 7, et deux cellules de mémoire volatile 202 et deux cellules de mémoire non volatile 204 sont illustrées dans chaque colonne, bien que dans des variantes de réalisation il puisse y avoir un nombre quelconque de colonnes et un nombre quelconque de cellules mémoires dans chaque colonne.

Le circuit de lecture/écriture comprend un module de lecture/écriture 702, et un multiplexeur de colonne (Col Mux) 704 associé à chaque colonne. Ainsi, dans le mode de réalisation de la figure 7A, le module de lecture/écriture 702 est associé à plus d'une seule colonne de la matrice mémoire. Dans des variantes de réalisation, un module de lecture/écriture 702 séparé pourrait être prévu pour chaque colonne de la matrice.

La figure 7B illustre plus en détail l'un des multi-plexeurs de colonne 704 selon un exemple de réalisation. En référence aux deux figures 7A et 7B, le multiplexeur de colonne 704 de la colonne COLO couple sélectivement les lignes de bit BL, BLB respectivement :
à des lignes d'écriture complémentaires wdl et nwdl lorsqu'un signal d'écriture wdec0 de la colonne COL0 est activé ;
à une tension d'alimentation VDD pour précharger les lignes de bit avant qu'une cellule volatile soit lue lorsqu'un signal de pré-charge blprechn est activé ;
à des lignes de lecture de cellule volatile complémentaires rsrdl, nrsrdl, lorsqu'un signal de lecture volatile rsrdec0 de la colonne COLO est activé ; et
à une ligne de lecture non volatile rsttrdl et à un niveau de tension de lecture, par exemple la masse, lorsqu'un signal de lecture non volatile rsttdec0 est activé.

Le multiplexeur de colonne 704 comprend par exemple :
deux transistors PMOS contrôlés par le signal blprechn pour coupler respectivement les lignes de bit BL et BLB à la tension d'alimentation VDD ;
deux transistors NMOS contrôlés par le signal wdec pour coupler respectivement les lignes de bit BL et BLB aux lignes d'écriture wdl et nwdl ;
deux transistors NMOS contrôlés par le signal rsrdec pour coupler respectivement les lignes de bit BL et BLB aux lignes de lecture volatile rsrdl et nrsrdl ; et
deux transistors NMOS contrôlés par le signal rsttdec pour coupler respectivement les lignes de bit BL et BLB à la ligne de lecture non volatile rsttrdl et la masse.

En faisant de nouveau référence à la figure 7A, le module de lecture/écriture 702 comprend un circuit d'écriture 706, qui génère des tensions à appliquer aux lignes de bit d'une colonne sélectionnée sur la base d'un signal d'écriture wrt provenant du bloc de commande 224, et d'un signal de données d provenant d'un multiplexeur de données 708. Le multiplexeur de données 708 sélectionne soit la donnée dext externe reçue de l'extérieur de la matrice mémoire, soit la donnée dint interne lue dans une cellule mémoire de la matrice, sur la base d'un signal de restauration rte.

Le module de lecture/écriture 702 comprend aussi un comparateur (Comp) 710, ayant des entrées positive et négative respectivement couplées aux lignes de lecture de cellule volatile nrsrdl et rsrdl. Une sortie du comparateur 710 est couplée à une bascule de données (Latch) 712, qui à son tour fournit le signal de donnée interne dint. Le comparateur 710 et la bascule 712 reçoivent chacun un signal de synchronisation compe. Le signal de données interne dint est fourni par l'intermédiaire d'un tampon de sortie 713 sous la forme du signal de données de sortie q du module de lecture/écriture 702.

La ligne de lecture de cellule non volatile rsttrdl est couplée à un circuit de bridage de tension (clamp) 714, qui applique un niveau de tension à la ligne rsttdrdl afin de générer un courant dans l'élément résistif d'une cellule de mémoire non volatile 204 sélectionnée. De façon similaire, le circuit de bridage de tension 714 applique aussi par exemple une tension à une ligne de référence refsttrdl couplée à un dispositif de référence (non illustré) de sorte qu'un courant de référence est généré. Le dispositif de référence a par exemple une résistance égale à (Rₘₐₓ+Rₘᵢₙ)/2, de sorte que le courant de référence fournit un niveau de coupure pour déterminer si l'élément résistif a une résistance programmée de Rₘᵢₙ ou Rₘₐₓ. Les courants générés par le circuit de bridage de tension 714 sont convertis en niveaux de tension et amplifiés par un amplificateur 716. Le circuit de bridage de tension 714 et l'amplificateur 716 reçoivent par exemple un signal de synchronisation ampe.

L'amplificateur 716 fournit des sorties de tension différentielles, qui à leur tour sont couplées par l'intermédiaire de commutateurs 718 aux entrées du comparateur 710. Les commutateurs 718 sont contrôlés par un signal de commande de lecture non volatile rdstte provenant du bloc de commande 224.

Un décodeur de rangée 720 est par exemple associé à chaque paire de rangées volatile/non volatile de la matrice mémoire. Le décodeur de rangée 720 reçoit une adresse de rangée, et lorsque l'adresse correspond à l'adresse de la rangée, active le signal de commande de rangée WLA correspondant lorsqu'un signal de sélection de rangée volatile wlsrame est activé, ou active le signal de commande de rangée WLB correspondant lorsqu'un signal de sélection de rangée non volatile wlsttrame est activé.

Le bloc de commande 224 reçoit un signal d'horloge clk, un signal d'adresse de rangée Row Ad, un signal d'adresse de colonne Col Ad, un signal d'activation d'écriture we, un signal de sélection de cellule non volatile stte, un signal de sélection de cellule volatile sre, un signal de sauvegarde save, et un signal de restauration restore.

On va maintenant décrire le fonctionnement de la mémoire 700 en référence à la figure 8.

La figure 8 est un chronogramme illustrant des exemples des signaux clk, save, restore, blprechn, wlsrame, wlsttrame, rsrdec0, rsttdec0, wdec0, rte, rdstte, ampe, compe, wrt, q, dint_stt and dint_sr, dans la matrice mémoire 700 de la figure 7A pendant une opération de sauvegarde et une opération de restauration entre les cellules de mémoire volatile et non volatile de la colonne COLO de la figure 7A. Le signal dint_stt correspond à la donnée mémorisée par la cellule de mémoire non volatile 204 et le signal dint_sr correspond à la donnée mémorisée par la cellule de mémoire volatile 202.

L'opération de sauvegarde est déclenchée par une valeur haute du signal save, et implique l'application des signaux de sélection wlsrame et wlsttrame des cellules de mémoire volatile et non volatile entre lesquelles le transfert doit avoir lieu. Après un temps d'écriture t_{wnv}, les signaux wlsrame et wlsttrame passent à l'état bas, et la donnée dint_stt mémorisée par la cellule de mémoire non volatile devient égale à la donnée volatile dint_sr.

L'opération de restauration est déclenchée par une valeur haute du signal de restauration, et commence par une opération de lecture de la donnée dint stt mémorisée dans la cellule de mémoire non volatile. Pendant l'opération de restauration, le signal rte est haut, de sorte que la donnée écrite dans la cellule de mémoire volatile est la donnée interne dint qui a été lue dans la cellule de mémoire non volatile.

Le signal wlsttrame passe à l'état haut pour activer le signal WLB et sélectionner la cellule de mémoire non volatile, et rsttdec0 passe à l'état haut pour coupler les lignes de bit à la masse et à la ligne de données de lecture rsttrdl. Le signal de synchronisation ampe passe ensuite à l'état haut pour activer le bridage de tension 714 et l'amplificateur 716, et le signal de synchronisation compe passe ensuite à l'état haut pour mémoriser le signal de données dans la bascule 712. Sur le front descendant du signal compe, le signal q passe au signal de donnée de cellule non volatile dint_stt.

L'opération de restauration implique ensuite une opération d'écriture dans la cellule volatile. Ainsi les signaux wlsrame et wdec0 sont hauts, et le signal d'écriture wrt passe aussi à l'état haut. Après un temps d'écriture t_{wv}, qui est par exemple plus court que le temps d'écriture t_{wnv} de la cellule non volatile, le signal d'écriture wrt passe à l'état bas, et la donnée dint_sr mémorisée par la cellule de mémoire non volatile devient égale à la donnée non volatile dint_stt.

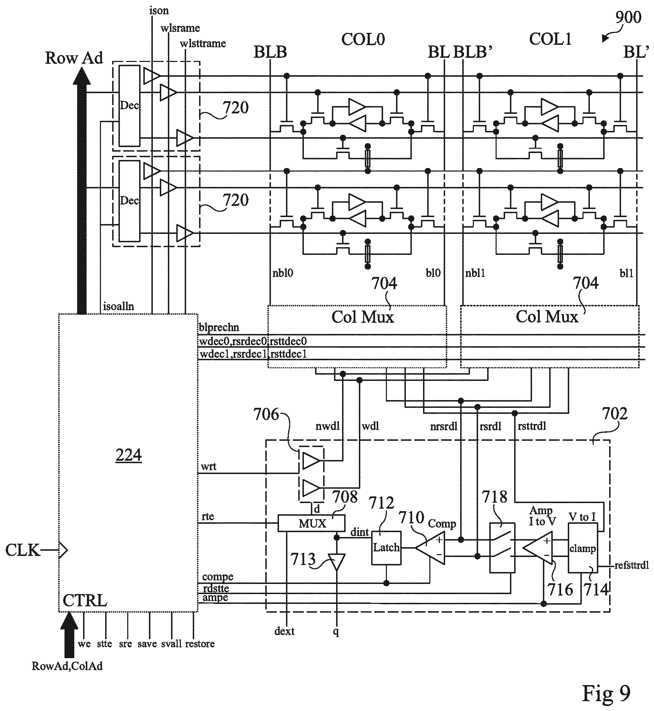

La figure 9 illustre schématiquement un dispositif mémoire 900 très similaire à celui de la figure 7, et les éléments similaires portent les mêmes références et ne seront pas décrits de nouveau en détail. Une différence est que les cellules de mémoire volatile et non volatile 202, 204 de la figure 9 sont couplées par paires, comme dans le mode de réalisation de la figure 5 décrit précédemment. Les décodeurs de rangées reçoivent un autre signal d'isolement isoalln indiquant le moment où une opération de sauvegarde doit être réalisée et les cellules mémoires doivent être isolées des lignes de bit correspondantes. En outre, en plus du signal de sélection wlsrame et wlsttrame, un autre signal de sélection ison sélectionne l'un des groupes de cellules mémoires pendant une opération de lecture ou d'écriture des cellules de mémoire volatile. Le circuit de commande de 224 reçoit en outre un signal svall indiquant le moment où une opération de sauvegarde doit être réalisée sur toutes les cellules de mémoire volatile de la matrice.

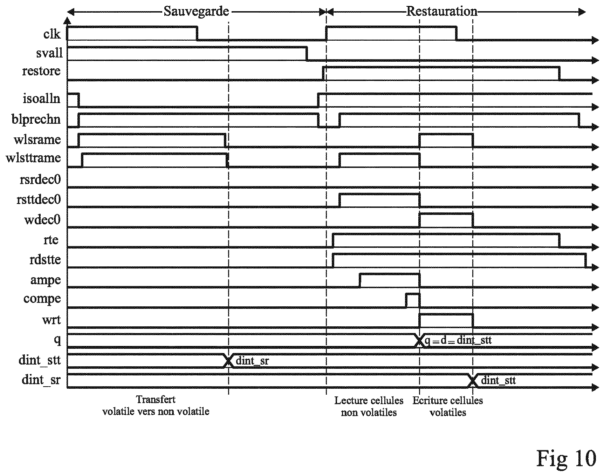

La figure 10 est un chronogramme illustrant des exemples des signaux clk, svall, restore, isoalln, blprechn, wlsrame, wlsttrame, rsrdec0, rsttdec0, wdec0, rte, rdstte, ampe, compe, wrt, q, dint_stt and dint_sr, dans la matrice mémoire 900 de la figure 9 pendant une opération de sauvegarde et une opération de restauration entre les cellules de mémoire volatile et non volatile de la colonne COL0. La différence par rapport au chronogramme de la figure 8 est que le signal de sauvegarde complète svall déclenche l'opération de sauvegarde, et pendant cette opération le signal isoalln est amené à l'état bas pour isoler les cellules mémoires des lignes de bits.

Un avantage des modes de réalisation décrits ici est que, en couplant les noeuds de mémorisation d'une cellule de mémoire volatile à des noeuds d'entrée d'une cellule de mémoire non volatile, une opération de sauvegarde dans laquelle la cellule de mémoire non volatile est écrite peut être réalisée de façon simple sans utiliser de circuit d'écriture dédié dans la matrice mémoire. En outre, dans un tel circuit, un circuit commun de lecture et/ou écriture peut être prévu pour les cellules de mémoire volatile et non volatile, et ainsi chaque cellule mémoire peut être mise en oeuvre avec relativement peu de transistors et aucun amplificateur de détection.

Avec la description ainsi faite d'au moins un mode de réalisation illustratif, diverses altérations, modifications et améliorations apparaîtront facilement à l'homme de l'art.

Par exemple, il sera clair pour l'homme de l'art que la tension d'alimentation V_{DD} dans les divers modes de réalisation pourrait être à un niveau quelconque, par exemple entre 1 et 3 V, et plutôt que d'être à 0 V, la tension de masse pourrait aussi être considérée comme une tension d'alimentation qui pourrait avoir un niveau quelconque, comme un niveau négatif.

En outre il sera clair pour l'homme de l'art que, dans tous les modes de réalisation décrits ici, tous les transistors NMOS pourraient être remplacés par des transistors PMOS et/ou tous les transistors PMOS pourraient être remplacés par des transistors NMOS. La façon dont tous ces circuits pourraient être mis en oeuvre en utilisant seulement des transistors PMOS ou seulement des transistors NMOS apparaîtra facilement à l'homme de l'art. En outre, bien qu'on ait décrit ici des transistors basés sur la technologie MOS, dans des variantes de réalisation on pourrait utiliser d'autres technologies de transistors, comme la technologie bipolaire.

En outre, il sera clair pour l'homme de l'art que les divers éléments décrits en relation avec les divers modes de réalisation pourraient être combinés, dans des variantes de réalisation, selon des combinaisons quelconques.

## Revendications

1. Matrice mémoire comprenant :
une pluralité de cellules de mémoire volatile (202), chaque cellule de mémoire volatile comportant des premier et deuxième inverseurs (206, 208) couplés de façon croisée entre des premier et deuxième noeuds de mémorisation (210, 212), le premier noeud de mémorisation (210) étant couplé à une première ligne de bit (BL) par l'intermédiaire d'un premier transistor (214) et le deuxième noeud de mémorisation (212) étant couplé à une deuxième ligne de bit (BLB) par l'intermédiaire d'un deuxième transistor (216) ;
une pluralité de cellules de mémoire non volatile (204), chaque cellule de mémoire non volatile étant couplée entre les première et deuxième lignes de bit (BL, BLB) et comportant un élément résistif (218, 218A, 218B) programmable pour prendre l'un d'au moins deux états résistifs (Rₘᵢₙ, Rₘₐₓ), l'élément résistif (218, 218A, 218B) étant couplé en série avec un troisième transistor (220, 220A, 220B) ; et
un circuit de commande (224) adapté à activer les premier, deuxième et troisième transistors pour coupler une première des cellules de mémoire non volatile aux premier et deuxième noeuds de mémorisation d'une première des cellules de mémoire volatile pour générer un courant pour programmer l'état résistif dudit au moins un élément résistif.

2. Matrice mémoire selon la revendication 1, dans laquelle ledit au moins un élément résistif est programmable par la direction d'un courant qu'on fait passer dans celui-ci pour prendre l'un desdits au moins deux états résistifs.

3. Matrice mémoire selon la revendication 1 ou 2, dans laquelle chaque cellule de mémoire non volatile comprend des premier et deuxième noeuds d'entrée (221, 222), et dans laquelle le circuit de commande (224) est adapté à coupler la première cellule de mémoire non volatile aux premier et deuxième noeuds de mémorisation de la première cellule de mémoire volatile en couplant le premier noeud d'entrée (221) au premier noeud de mémorisation et en couplant le deuxième noeud d'entrée (222) au deuxième noeud de mémorisation.

4. Matrice mémoire selon la revendication 3, dans laquelle chaque cellule de mémoire non volatile comprend un seul élément résistif (218) couplé en série avec le troisième transistor (220) entre les premier et deuxième noeuds d'entrée (221, 222).

5. Matrice mémoire selon la revendication 4, dans laquelle chaque cellule de mémoire non volatile comprend :
le premier élément résistif (218A) couplé en série avec le troisième transistor (220A) entre le premier noeud d'entrée (221) et un premier niveau de tension (V_{I}) ; et
un deuxième élément résistif (218B) couplé en série avec un quatrième transistor (220B) entre le deuxième noeud d'entrée (222) et le premier niveau de tension (V_{I}).

6. Matrice mémoire selon l'une quelconque des revendications 3 à 5, dans laquelle :
le premier transistor (214) est couplé entre le premier noeud de mémorisation (210) et le premier noeud d'entrée (221) de la cellule de mémoire non volatile ;
le deuxième transistor (216) est couplé entre le deuxième noeud de mémorisation (212) et le deuxième noeud d'entrée (222) de la cellule de mémoire non volatile.

7. Matrice mémoire selon l'une quelconque des revendication 3 à 6, dans laquelle :
le premier noeud d'entrée (221) est connecté à un premier noeud interne (402) ;
le deuxième noeud d'entrée (222) est connecté à un deuxième noeud interne (404) ;
le premier noeud de mémorisation (210) est couplé au premier noeud interne (402) par l'intermédiaire du premier transistor (214) ;
le deuxième noeud de mémorisation (212) est couplé au deuxième noeud interne (404) par l'intermédiaire du deuxième transistor (216) ;
le premier noeud interne (402) est couplé à la première ligne de bit (BL) par l'intermédiaire d'un cinquième transistor (406) ;
le deuxième noeud interne (404) est couplé à la deuxième ligne de bit (BLB) par l'intermédiaire d'un sixième transistor (408) ; et
le circuit de commande (224) est adapté à désactiver les cinquième et sixième transistors pendant le couplage de la première cellule de mémoire non volatile aux premier et deuxième noeuds de mémorisation.

8. Matrice mémoire selon la revendication 7, dans laquelle :
une deuxième des cellules de mémoire volatile comporte des troisième et quatrième inverseurs (206, 208) couplés de façon croisée entre des troisième et quatrième noeuds de mémorisation (210, 212), le troisième noeud de mémorisation étant couplé au premier noeud interne (402) par l'intermédiaire d'un septième transistor (214) et le quatrième noeud de mémorisation étant couplé au deuxième noeud interne (404) par l'intermédiaire d'un huitième transistor (216) ; et
une deuxième des cellules de mémoire non volatile comporte : au moins un élément résistif (218, 218A, 218B) programmable pour prendre l'un d'au moins deux états résistifs (Rₘᵢₙ, Rₘₐₓ) ; un troisième noeud d'entrée (221) connecté au premier noeud interne (402) ; et un quatrième noeud d'entrée (222) connecté au deuxième noeud interne (404).

9. Matrice mémoire selon l'une quelconque des revendications 1 à 8, comprenant en outre un circuit de lecture/écriture (223) adapté à lire dans la première cellule de mémoire non volatile un état résistif programmé représentant un premier bit de donnée et à écrire le premier bit de données dans la première cellule de mémoire volatile.

10. Matrice mémoire selon l'une quelconque des revendications 1 à 9, dans laquelle chacune des cellules de mémoire volatile (202) est couplée à un rail d'alimentation en tension (610) couplé par l'intermédiaire d'un commutateur (612) à un niveau de tension d'alimentation (VDD).

11. Matrice mémoire selon l'une quelconque des revendications 1 à 10, dans laquelle ledit un élément résistif (218, 218A, 218B) de chacune des cellules de mémoire non volatile (204) est de l'un des types suivants :
un élément à couple de transfert de spin ayant une anisotropie dans le plan ;
un élément à couple de transfert de spin ayant une anisotropie perpendiculaire au plan ; et
un élément à oxydoréduction (RedOx).

12. Procédé de sauvegarde de données dans la matrice mémoire de l'une quelconque des revendications 1 à 11, le procédé comprenant :
coupler, par un circuit de commande (224), la première cellule de mémoire non volatile aux premier et deuxième noeuds de mémorisation de la première cellule de mémoire volatile pour générer un courant pour programmer l'état résistif dudit élément résistif.

13. Procédé de restauration de données dans la matrice mémoire de l'une quelconque des revendications 1 à 11, le procédé comprenant :
lire dans la première cellule de mémoire non volatile un état résistif programmé représentant un premier bit de données ; et
écrire le premier bit de données dans la première cellule de mémoire volatile.

## Patentansprüche

1. Speicheranordnung, die Folgendes aufweist:
eine Vielzahl von flüchtigen Speicherzellen (202), wobei jede flüchtige Speicherzelle erste und zweite Inverter (206, 208) aufweist, die zwischen ersten und zweiten Speicherknoten (210, 212) kreuzgekoppelt sind, wobei der erste Speicherknoten (210) über einen ersten Transistor (214) mit einer ersten Bitleitung (BL) und der zweite Speicherknoten (212) über einen zweiten Transistor (216) mit einer zweiten Bitleitung (BLB) gekoppelt sind;
eine Vielzahl von nichtflüchtigen Speicherzellen (204), wobei jede nichtflüchtige Speicherzelle zwischen den ersten und zweiten Bitleitungen (BL, BLB) gekoppelt ist und ein Widerstandselement (218, 218A, 218B) aufweist, das programmierbar ist, um einen von wenigstens zwei Widerstandszuständen (Rₘᵢₙ, Rₘₐₓ) zu haben, wobei das Widerstandselement (218, 218A, 218B) in Reihe mit einem dritten Transistor (220, 220A, 220B) gekoppelt ist; und
eine Steuerschaltung (224), die konfiguriert ist, um die ersten, zweiten und dritten Transistoren zu aktivieren, um eine erste der nichtflüchtigen Speicherzellen mit den ersten und zweiten Speicherknoten einer ersten der flüchtigen Speicherzellen zu koppeln, um einen Strom zur Programmierung des Widerstandszustands des wenigstens einen Widerstandselements zu erzeugen.

2. Speicheranordnung nach Anspruch 1, wobei das wenigstens eine Widerstandselement über die Richtung des Stroms, der durch das Widerstandselement geleitet wird, programmierbar ist, um einen der wenigstens zwei Widerstandszustände zu haben.

3. Speicheranordnung nach Anspruch 1 oder 2, wobei jede nichtflüchtige Speicherzelle erste und zweite Eingangsknoten (221, 222) aufweist, und wobei die Steuerschaltung (224) konfiguriert ist, um die erste nichtflüchtige Speicherzelle mit den ersten und zweiten Speicherknoten der ersten flüchtigen Speicherzelle zu koppeln, indem sie den ersten Eingangsknoten (221) mit dem ersten Speicherknoten und den zweiten Eingangsknoten (222) mit dem zweiten Speicherknoten koppelt.

4. Speicheranordnung nach Anspruch 3, wobei jede nichtflüchtige Speicherzelle ein einzelnes Widerstandselement (218) aufweist, das in Reihe mit dem dritten Transistor (220) geschaltet ist, und zwar zwischen den ersten und zweiten Eingangsknoten (221, 222).

5. Speicheranordnung nach Anspruch 4, wobei jede nichtflüchtige Speicherzelle Folgendes aufweist:
das erste Widerstandselement (218A) ist in Reihe mit dem dritten Transistor (220A) geschaltet, und zwar zwischen dem ersten Eingangsknoten (221) und einem ersten Spannungspegel (V_{I}); und
ein zweites Widerstandselement (218B), das in Reihe mit einem vierten Transistor (220B) geschaltet ist, und zwar zwischen dem zweiten Eingangsknoten (222) und dem ersten Spannungspegel (V_{I}).

6. Speicheranordnung nach einem der Ansprüche 3 bis 5, wobei:
der erste Transistor (214) zwischen den ersten Speicherknoten (210) und den ersten Eingangsknoten (221) der nichtflüchtigen Speicherzelle gekoppelt ist;
der zweite Transistor (216) zwischen den zweiten Speicherknoten (212) und den zweiten Eingangsknoten (222) der nichtflüchtigen Speicherzelle gekoppelt ist.

7. Speicheranordnung nach einem der Ansprüche 3 bis 6, wobei:
der erste Eingangsknoten (221) mit einem ersten internen Knoten (402) verbunden ist;
der zweite Eingangsknoten (222) mit einem zweiten internen Knoten (404) verbunden ist;
der erste Speicherknoten (210) über den ersten Transistor (214) mit dem ersten internen Knoten (402) gekoppelt ist;
der zweite Speicherknoten (212) über den zweiten Transistor (216) mit dem zweiten internen Knoten (404) gekoppelt ist;
der erste interne Knoten (402) über einen fünften Transistor (406) mit der ersten Bitleitung (BL) gekoppelt ist;
der zweite interne Knoten (404) über einen sechsten Transistor (408) mit der zweiten Bitleitung (BLB) gekoppelt ist; und
die Steuerschaltung (224) konfiguriert ist, um die fünften und sechsten Transistoren zu deaktivieren, während die erste nichtflüchtige Speicherzelle mit den ersten und zweiten Speicherknoten gekoppelt ist.

8. Speicheranordnung nach Anspruch 7, wobei:
eine zweite der flüchtigen Speicherzellen dritte und vierte Inverter (206, 208) aufweist, die zwischen dritten und vierten Speicherknoten (210, 212) kreuzgekoppelt sind, wobei der dritte Speicherknoten über einen siebten Transistor (214) mit dem ersten internen Knoten (402) und der vierte Speicherknoten über einen achten Transistor (216) mit dem zweiten internen Knoten (404) gekoppelt ist; und
eine zweite der nichtflüchtigen Speicherzellen folgendes aufweist: wenigstens ein Widerstandselement (218, 218A, 218B), das programmierbar ist, um einen von wenigstens zwei Widerstandszuständen (Rₘᵢₙ, Rₘₐₓ) zu haben; einen dritten Eingangsknoten (221), der mit dem ersten internen Knoten (402) verbunden ist; und einen vierten Eingangsknoten (222), der mit dem zweiten internen Knoten (404) verbunden ist.

9. Speicheranordnung nach einem der Ansprüche 1 bis 8, ferner aufweisend eine Lese-/Schreibschaltung (223), die konfiguriert ist, um aus der ersten nichtflüchtigen Speicherzelle einen programmierten Widerstandszustand auszulesen, der ein erstes Datenbit darstellt, und um das erste Datenbit in die erste flüchtige Speicherzelle zu schreiben.

10. Speicheranordnung nach einem der Ansprüche 1 bis 9, wobei jede der flüchtigen Speicherzellen (202) mit einer Spannungsversorgungsschiene (610) gekoppelt ist, die über einen Schalter (612) mit einem Versorgungsspannungspegel (VDD) gekoppelt ist.

11. Speicheranordnung nach einem der Ansprüche 1 bis 10, wobei das Widerstandselement (218, 218A, 218B) jeder der nichtflüchtigen Speicherzellen (204) eines der folgenden ist:
ein Spin-Transfer-Torque-Element mit in Ebene Anisotropie;
ein Spin-Transfer-Torque-Element mit senkrecht zur Ebene stehender Anisotropie; und
ein Reduktionsoxid (RedOx)-Element.

12. Verfahren zur Datensicherung in der Speicheranordnung nach einem der Ansprüche 1 bis 11, wobei das Verfahren Folgendes aufweist:
Koppeln, durch eine Steuerschaltung (224), der ersten nichtflüchtigen Speicherzelle mit den ersten und zweiten Speicherknoten der ersten flüchtigen Speicherzelle um einen Strom zum Programmieren des Widerstandszustands des Widerstandselements zu erzeugen.

13. Verfahren zum Wiederherstellen von Daten in der Speicheranordnung nach einem der Ansprüche 1 bis 11, wobei das Verfahren Folgendes aufweist:
Lesen eines programmierten Widerstandszustands, der ein erstes Datenbit darstellt, aus der ersten nichtflüchtigen Speicherzelle; und
Schreiben des ersten Datenbits in die erste flüchtige Speicherzelle.

## Claims

1. A memory array comprising:
a plurality of volatile memory cells (202), each volatile memory cell having first and second inverters (206, 208) cross-coupled between first and second storage nodes (210, 212), the first storage node (210) being coupled to a first bit line (BL) via a first transistor (214) and the second storage node (212) being coupled to a second bit line (BLB) via a second transistor (216);
a plurality of non-volatile memory cells (204), each non-volatile memory cell being coupled between the first and second bit lines (BL, BLB) and having a resistive element (218, 218A, 218B) programmable to have one of at least two resistive states (Rₘᵢₙ, Rₘₐₓ), the resistive element (218, 218A, 218B) being coupled in series with a third transistor (220, 220A, 220B); and
a control circuit (224) adapted to activate the first, second and third transistors in order to couple a first of the non-volatile memory cells to the first and second storage nodes of a first of the volatile memory cells to generate a current for programming the resistive state of the at least one resistive element.

2. The memory array of claim 1, wherein the at least one resistive element is programmable by the direction of current passed through it to have one of said at least two resistive states.

3. The memory array of claim 1 or 2, wherein each non-volatile memory cell comprises first and second input nodes (221, 222), and wherein the control circuit (224) is adapted to couple the first non-volatile memory cell to the first and second storage nodes of the first volatile memory cell by coupling the first input node (221) to the first storage node and by coupling the second input node (222) to the second storage node.

4. The memory array of claim 3, wherein each non-volatile memory cell comprises a single resistive element (218) coupled in series with the third transistor (220) between the first and second input nodes (221, 222).

5. The memory array of claim 4, wherein each non-volatile memory cell comprises:
the first resistive element (218A) coupled in series with the third transistor (220A) between the first input node (221) and a first voltage level (V_{I}) ; and
a second resistive element (218B) coupled in series with a fourth transistor (220B) between the second input node (222) and the first voltage level (V_{I}).

6. The memory array of any of claims 3 to 5, wherein:
the first transistor (214) is coupled between the first storage node (210) and the first input node (221) of the non-volatile memory cell;
the second transistor (216) is coupled between the second storage node (212) and the second input node (222) of the non-volatile memory cell.

7. The memory array of any of claims 3 to 6, wherein:
the first input node (221) is connected to a first internal node (402);
the second input node (222) is connected to a second internal node (404);
the first storage node (210) is coupled to the first internal node (402) via the first transistor (214);
the second storage node (212) is coupled to the second internal node (404) via the second transistor (216);
the first internal node (402) is coupled to the first bit line (BL) via a fifth transistor (406);
the second internal node (404) is coupled to the second bit line (BLB) via a sixth transistor (408); and
the control circuit (224) is adapted to deactivate the fifth and sixth transistors while coupling the first non-volatile memory cell to the first and second storage nodes.

8. The memory array of claim 7, wherein:
a second of the volatile memory cells has third and fourth inverters (206, 208) cross-coupled between third and fourth storage nodes (210, 212), the third storage node being coupled to the first internal node (402) via a seventh transistor (214) and the fourth storage node being coupled to said second internal node (404) via an eighth transistor (216); and
a second of the non-volatile memory cells has: at least one resistive element (218, 218A, 218B) programmable to have one of at least two resistive states (Rₘᵢₙ, Rₘₐₓ); a third input node (221) connected to the first internal node (402); and a fourth input node (222) connected to said second internal node (404).

9. The memory array of any of claims 1 to 8, further comprising a read/write circuit (223) adapted to read from the first non-volatile memory cell a programmed resistive state representing a first data bit and to write the first data bit to the first volatile memory cell.

10. The memory array of any of claims 1 to 9, wherein each of the volatile memory cells (202) is coupled to a voltage supply rail (610) coupled via a switch (612) to a supply voltage level (VDD).

11. The memory array of any of claims 1 to 10, wherein said resistive element (218, 218A, 218B) of each of said non-volatile memory cells (204) is one of:
a spin transfer torque element with in-plane anisotropy;
a spin transfer torque element with perpendicular-to-plane anisotropy; and
a reduction oxide (RedOx) element.

12. A method of data back-up in the memory array of any of claims 1 to 11, the method comprising:
coupling, by a control circuit (224), the first non-volatile memory cell to the first and second storage nodes of the first volatile memory cell to generate a current for programming the resistive state of the resistive element.

13. A method of restoring data in the memory array of any of claims 1 to 11, the method comprising:
reading from the first non-volatile memory cell a programmed resistive state representing a first data bit; and
writing the first data bit to the first volatile memory cell.
